# EUROPEAN PATENT APPLICATION

(11) **EP 3 875 187 A1**
(43) Date of publication of application: **08.09.2021**
(21) Application number: 21158483.4
(22) Date of filing: 22.02.2021
(51) Int. Cl.: B22F 10/00, B29C 64/00, F28D 1/02, F28F 7/02

(54) **DIRECTED ENERGY DEPOSITION OF HEAT EXCHANGE FINS**

(30) Priority: 02.03.2020 US 202016805977
(71) Applicant: Hamilton Sundstrand Corporation, Charlotte, NC 28217-4578 (US)
(72) Inventor: SOLOMON, Andrew W., Windson, CT Connecticut 06095 (US); SYPEK, John, Chicopee, MA Massachusetts 01013 (US)
(74) Representative: Dehns

(57) **Abstract**

A method includes forming an electronics housing (102) defining a first flow path (104) spaced apart from a second flow path (108) for heat exchange through the housing between the first and second flow paths. The electronics housing is of a first material. The method includes depositing a heat exchange fin on the electronics housing. The heat exchange fin is of a second material different from the first material, wherein the heat exchange fin is grown into the second flow path to facilitate heat exchange between the first flow path and the second flow path.

## Description

### BACKGROUND

### 1. Field

The present disclosure relates to heat exchangers, and more particularly to heat exchange fins for heat exchangers.

### 2. Description of Related Art

Legacy methods of electronic cooling in aerospace housings limit channel dimensions, and other features. Additionally, optimization of liquid pressure drop is limited within the cooling channel of the electronics housing and potentially external to the air stream. The limitation is a product of the legacy manufacturing processes.

The conventional techniques have been considered satisfactory for their intended purpose. However, there is an ever present need for improved systems and methods for heat exchangers. This disclosure provides a solution for this need.

### SUMMARY

A method includes forming an electronics housing defining a first flow path spaced apart from the second flow path for heat exchange through the housing between the first and second flow paths. The electronics housing is of a first material. The method includes depositing a heat exchange fin on the electronics housing. The heat exchange fin is of a second material different from the first material, wherein the heat exchange fin is grown into the second flow path to facilitate heat exchange between the first flow path and the second flow path.

Depositing the heat exchange fin can include using directed energy deposition (DED) to join the second material to the first material. Depositing the heat exchange fin can include using DED to deposit the second material, wherein the second material includes at least one of copper, nickel, aluminum, and/or gold, onto the first material. Depositing the heat exchange fin can include using DED to deposit the second material, wherein the first material includes at least one of aluminum, nickel, and/or titanium. Depositing the heat exchange fin can include depositing the heat exchange fin in the second flow path, wherein the second flow path is an external flow path that is external of the housing. Depositing the heat exchange fin can include depositing the heat exchange fin in the second flow path, wherein the second flow path is an internal flow path defined through the housing. Forming the housing can include forming a channel in the first material. Depositing the heat exchange fin can include depositing the second material in the channel to grow the heat exchange fin out of the channel.

A heat exchanger includes an electronics housing defining a first flow path and a second flow path spaced apart from the first flow path, wherein the electronics housing is of a first material. A heat exchange fin is deposited on the housing in the second flow path. The heat exchange fin is of a second material different from the first material.

The first material can include at least one of aluminum and/or titanium. The second material can include at least one of copper, nickel, and/or gold. The second flow path can be an external flow path. The second flow path can be an internal flow path defined through the housing. The housing can include a channel defined in the first material, wherein the second material of the heat exchange fin is deposited in the channel. The fin can be a pin fin. It is also contemplated that the fin can be an elongated fin. The first material can have a higher material strength than second material. The second material can have a higher thermal conductivity than the first material.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below, by way of example only and with reference to certain figures, wherein:
Fig. 1 is a schematic perspective view of an embodiment of a heat exchanger constructed in accordance with the present disclosure, showing the first and second flow paths and the heat exchange fin; and
Fig. 2 is a cross-sectional side elevation view of the heat exchanger of Fig. 1, showing the channels into which the fins are deposited viewed in the direction indicated with the cross-section label in Fig. 1.

### DETAILED DESCRIPTION OF THE PREFERRED EMBODIMENTS

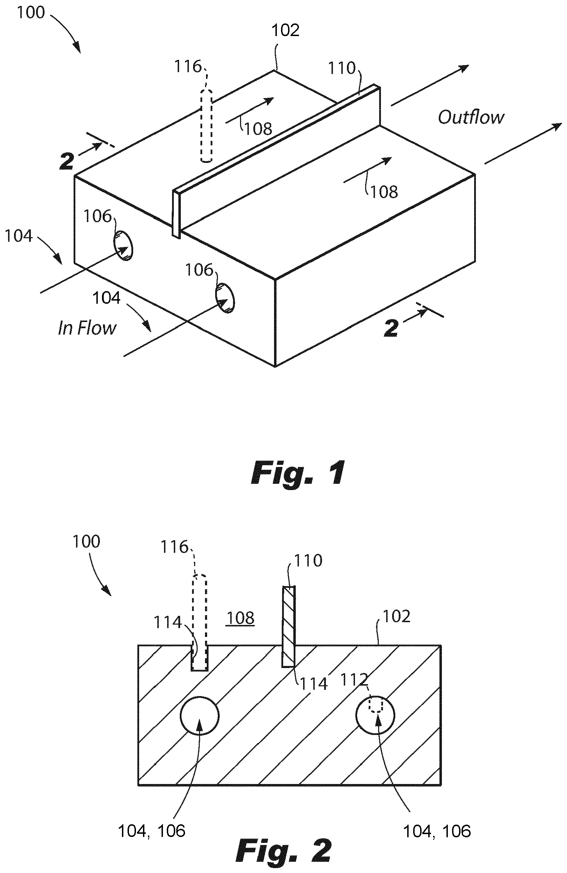

Reference will now be made to the drawings wherein like reference numerals identify similar structural features or aspects of the subject disclosure. For purposes of explanation and illustration, and not limitation, a partial view of an embodiment of a heat exchanger in accordance with the disclosure is shown in Fig. 1 and is designated generally by reference character 100. Other embodiments of systems in accordance with the disclosure, or aspects thereof, are provided in Fig. 2, as will be described. The systems and methods described herein can be used to improve heat exchanger performance, e.g. for maintaining avionics temperatures.

The heat exchanger 100 includes an electronics housing 102 defining a first flow path 104 (including two internal flow passages 106 as shown in Fig. 1, but any suitable number of internal flow passages can be used without departing from the scope of this disclosure). A second flow path 108, which may be an external flow path, is spaced apart from the first flow path 104. A heat exchange fin 110 is deposited on the housing 102 and in the second flow path 108. Optionally, a fin 112 can be included within the internal flow passages 106, as indicated in broken lines in Fig. 2.

The electronics housing 102 is of a first material and the heat exchange fin 110 is of a second material different from the first material. The first material (of the electronics housing 102) can include at least one of aluminum, nickel, and/or titanium, and can be selected or optimized for material strength. The second material (of the heat exchanger fin 110) can include at least one of copper, nickel, aluminum, and/or gold, and can be selected or optimized for heat transfer. The first and second materials can be selected or optimized separately from one another for their respective functions, e.g., the first material can have a higher material strength than second material and the second material can have a higher thermal conductivity than the first material.

With reference now to Fig. 2, the housing 102 can include a channel 114 defined in the first material, wherein the second material of the heat exchange fin 110 is deposited in the channel 114. The fin 110 can be an elongated fin, e.g., extending along the housing 102 in the direction of the second flow path 108. It is also contemplated that the fin can be a pin fin 116 (or a series of pin fins), as indicated in broken lines in Figs. 1 and 2. Those skilled in the art will readily appreciate that any suitable number of fins 110 and/or 116 can be included without departing from the scope of this disclosure.

A method includes forming an electronics housing (e.g. housing 102) defining a first flow path spaced apart from the second flow path for heat exchange through the housing between the first and second flow paths (e.g. flow paths 104, 108). The electronics housing is of a first material. The method includes depositing a heat exchange fin (e.g. fin 110, 116) on the electronics housing, wherein the heat exchange fin is of a second material different from the first material. The heat exchange fin is grown into the second flow path to facilitate heat exchange between the first flow path and the second flow path.

Depositing the heat exchange fin can include using directed energy deposition (DED) to join the second material to the first material. Through this technique, the first material is deposited layer by layer on top of the second material in order to form the desired geometry, including but not limited to pins and fins. Depositing the heat exchange fin can include using DED to deposit the first material, wherein the first material includes at least one of copper, nickel, and/or gold, onto the second material. Depositing the heat exchange fin can include using DED to deposit the first material, wherein the second material includes at least one of aluminum and/or titanium. Depositing the heat exchange fin can include depositing the heat exchange fin in the second flow path, wherein the second flow path is an external flow path. Depositing the heat exchange fin can include depositing the heat exchange fin in the second flow path, wherein the second flow path is an internal flow path defined through the housing. Forming the housing can include forming a channel in the first material. Depositing the heat exchange fin can include depositing the second material in the channel to grow the heat exchange fin out of the channel.

The methods and systems of the present disclosure, as described above and shown in the drawings, provide for potential to optimize thermal performance, weight, and packaging in heat exchangers used in, for example, avionics applications by separately optimizing the housing or substrate material for a desired housing strength or dimensional stability and optimizing fins or protrusions from the housing or substrate for heat exchange efficiency. The present disclosure also can provide improvements in pressure drop internal to the fluid channel and external to the air stream, and can provide improved efficiency and useful life for the avionics and the associated heat exchanger housing. While the apparatus and methods of the subject disclosure have been shown and described with reference to preferred embodiments, those skilled in the art will readily appreciate that changes and/or modifications may be made thereto without departing from the scope of the subject disclosure as defined by the claims.

## Claims

1. A method comprising:
forming a housing (102) defining a first flow path (104) spaced apart from a second flow path (108) for heat exchange through the housing between the first and second flow paths, wherein the housing is of a first material; and
depositing a heat exchange fin (110) on the housing, wherein the heat exchange fin is of a second material different from the first material, wherein the heat exchange fin is grown into the second flow path.

2. The method as recited in claim 1, wherein depositing the heat exchange fin includes using directed energy deposition (DED) to join the second material to the first material.

3. The method as recited in claim 2, wherein depositing the heat exchange fin includes using DED to deposit the second material, wherein the second material includes at least one of copper, nickel, aluminum, and/or gold, onto the first material.

4. The method as recited in claim 2 or 3, wherein depositing the heat exchange fin includes using DED to deposit the second material, wherein the first material includes at least one of aluminum, nickel and/or titanium.

5. The method as recited in any preceding claim, wherein depositing the heat exchange fin includes depositing the heat exchange fin in the second flow path, wherein the second flow path is an external flow path that is external of the housing.

6. The method as recited in any preceding claim, wherein depositing the heat exchange fin includes depositing the heat exchange fin in an internal flow path defined through the housing.

7. The method as recited in any preceding claim, wherein forming the housing includes forming a channel (114) in the first material, and wherein depositing the heat exchange fin includes depositing the second material in the channel to grow the heat exchange fin out of the channel.

8. A heat exchanger (100) comprising:
an housing (102) defining a first flow path (104) and a second flow path (108) spaced apart from the first flow path, wherein the housing is of a first material; and
a heat exchange fin (110) deposited on the housing in the second flow path, wherein the heat exchange fin is of a second material different from the first material.

9. The heat exchanger as recited in claim 8, wherein the second material includes at least one of copper, nickel, and/or gold; and optionally wherein the first material includes at least one of aluminum and/or titanium.

10. The heat exchanger as recited in claim 8 or 9, wherein the second flow path is an external flow path.

11. The heat exchanger as recited in claim 8 or 9, wherein the second flow path is an internal flow path defined through the housing.

12. The heat exchanger as recited in any of claims 8 to 11, wherein the housing includes a channel (1140 defined in the first material, and wherein the second material of the heat exchange fin is deposited in the channel.

13. The heat exchanger as recited in any of claim 8 to 12, wherein the fin is a pin fin (116) or wherein the fin is an elongated fin.

14. The heat exchanger as recited in any of claims 8 to 13, wherein the first material has a higher material strength than second material.

15. The heat exchanger as recited in any of claims 8 to 14, wherein the second material has higher thermal conductivity than the first material.
